(19) Europäisches Patentamt
European Patent Office
Office européen des brevets

(11) **EP 3 948 316 B1**

(12) **FASCICULE DE BREVET EUROPEEN**

(45) Date de publication et mention
de la délivrance du brevet:
**08.05.2024   Bulletin 2024/19**

(21) Numéro de dépôt: **20712969.3**

(22) Date de dépôt: **24.03.2020**

(51) Classification Internationale des Brevets (IPC):
**G01R 31/36** (2020.01)        **G01R 31/3835** (2019.01)

(52) Classification Coopérative des Brevets (CPC):
**G01R 31/3648; G01R 31/3835**

(86) Numéro de dépôt international:
**PCT/EP2020/058058**

(87) Numéro de publication internationale:
**WO 2020/200897 (08.10.2020 Gazette 2020/41)**

(54) **PROCÉDÉ D'INITIALISATION DE L'ÉTAT DE CHARGE D'UNE BATTERIE**

VERFAHREN ZUR INITIALISIERUNG DES LADEZUSTANDES EINER BATTERIE

METHOD FOR INITIALISING THE CHARGE STATE OF A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **03.04.2019   FR 1903547**

(43) Date de publication de la demande:
**09.02.2022   Bulletin 2022/06**

(73) Titulaires:
• **Ampere SAS**
  **92100 Boulogne-Billancourt (FR)**
• **NISSAN MOTOR Co., Ltd.**
  **Yokohama-shi, Kanagawa 221-0023 (JP)**

(72) Inventeurs:
• **ANA-LUCIA, Driemeyer Franco**
  **78180 Montigny Le Bretonneux (FR)**
• **EDDAHECH, Akram**
  **78280 Guyancourt (FR)**

(74) Mandataire: **Renault Group**
**Renault s.a.s.**
**1 avenue du Golf**
**FR TCR AVA 055**
**78084 Guyancourt Cedex (FR)**

(56) Documents cités:
EP-A1- 2 101 183        WO-A1-2006/098594
US-A1- 2009 256 524     US-A1- 2014 225 621
US-A1- 2016 272 080     US-A1- 2017 106 760

EP 3 948 316 B1

**Description**

[La présente invention concerne un procédé d'initialisation de l'état de charge d'un dispositif de stockage d'énergie électrochimique, plus particulièrement d'une batterie d'accumulateurs. Elle s'applique notamment, mais non exclusivement, au domaine de la gestion des batteries de traction pour les véhicules électriques et hybrides rechargeables.

Dans le domaine des véhicules électriques et hybrides, l'un des principaux enjeux des systèmes de gestion des batteries de traction est l'estimation de l'état de charge de la batterie, ou SOC (acronyme pour l'expression anglosaxonne « State of Charge »). L'état de charge est un paramètre essentiel dans la gestion électronique d'une batterie. Il représente la quantité d'énergie électrique que peut fournir une batterie d'accumulateurs à un moment déterminé, exprimée en pourcentage de sa capacité nominale. Plus l'état de charge est estimé précisément, plus la batterie est exploitée au mieux de ses performances tout en maximisant sa durée de vie. Une méthode connue pour déterminer l'état de charge d'une batterie en cours de fonctionnement consiste à effectuer, en fonction du temps, l'intégration de l'intensité du courant (de charge ou décharge) traversant la batterie. Outre la fiabilité et la robustesse de l'intégrateur, la fiabilité d'une telle méthode repose aussi sur la phase d'initialisation de l'état de charge au réveil de la batterie. Cette phase d'initialisation joue en effet un rôle important pour s'assurer de la convergence des estimations et donc de la précision de l'état de charge estimé.

On connaît du document EP2101183A1 une méthode de détermination de l'état de charge d'une batterie, qui inclue une phase d'initialisation de l'état de charge estimé de la batterie au démarrage du véhicule, soit lorsque le fonctionnement de la batterie commence. Selon cette méthode connue, on calcule une première valeur d'état de charge de la batterie sur la base de la tension en circuit ouvert (OCV) de la batterie lors du démarrage du véhicule et on stocke dans une mémoire une seconde valeur résultant du calcul d'état de charge à l'arrêt du véhicule, soit lorsque le fonctionnement de la batterie est terminé. On effectue alors une comparaison entre la première valeur d'état de charge calculée et la seconde valeur d'état de charge mémorisée et on sélectionne en tant que valeur initiale d'état de charge la première valeur calculée si le résultat de la comparaison, en valeur absolue, est inférieur à un seuil, et la seconde valeur mémorisée, sinon. Ainsi, dans le cas où la première valeur calculée à partir de la tension en circuit ouvert au démarrage a une fiabilité faible, la deuxième valeur mémorisée est définie comme valeur initiale d'état de charge.

Le document US2014/225621A1 présente des inconvénients similaires.

Cependant, cette méthode d'estimation de la valeur initiale de l'état de charge de la batterie est imprécise dans certains cas d'usage et, en particulier, lorsque le temps de relaxation de la batterie a été trop court. Classiquement, les périodes de charge et/ou de décharge de la batterie sont séparées par des périodes de relaxation, au cours desquelles la batterie n'est pas traversée par un courant. Au bout d'un certain temps de relaxation, la batterie atteint un état d'équilibre. C'est une fois cet état d'équilibre atteint qu'il est alors possible de mesurer la tension à vide (circuit ouvert) aux bornes de la batterie, qui correspond à sa force électromotrice à l'équilibre. Or, selon le type de batterie, un temps de relaxation de plusieurs minutes à plusieurs heures est nécessaire pour atteindre l'état d'équilibre. Plus précisément, le temps de relaxation nécessaire pour atteindre l'état d'équilibre dépend du degré de polarisation des électrodes, qui dépend luimême notamment de l'intensité du courant ayant traversé la batterie, ainsi que de la durée d'application de ce courant. Aussi, toute détermination de la force électromotrice hors de l'état d'équilibre affecte la précision de l'estimation de l'état de charge. Dans la mesure où la méthode d'initialisation de l'état de charge selon le document précité ne prend en considération ni la polarisation de la batterie, ni la durée de relaxation de la batterie, cette méthode ne devrait être réalisée qu'après une longue période de repos de la batterie, sauf à être imprécise.

La présente invention a alors pour but de fournir un procédé permettant d'estimer une valeur initiale de l'état de charge d'une batterie dans un véhicule automobile, en s'affranchissant des limitations précédemment évoquées.

A cette fin, l'invention concerne un procédé d'estimation de l'état de charge d'une batterie comprenant une phase d'initialisation de l'état de charge de la batterie incluant d'estimer une valeur initiale dudit état de charge, ladite phase d'initialisation comprenant des étapes de :

réception d'une valeur mémorisée d'état de charge de la batterie à un instant d'endormissement de la batterie,
calcul d'une valeur d'état de charge à partir d'une mesure de la tension à vide aux bornes de la batterie à un instant de réveil de la batterie,
la phase d'initialisation comprenant une étape de calcul d'une erreur sur la mesure de la tension à vide due à la relaxation de la batterie, dans laquelle ladite erreur est calculée en fonction de la température courante de la batterie et d'une durée de relaxation cible de la batterie modélisée pour chaque température,
l'estimation de la valeur initiale dudit état de charge étant calculée sur la base d'une comparaison entre lesdites valeurs mémorisée et calculées d'état de charge et en fonction de ladite erreur calculée.

Une telle estimation permet une estimation fiable de la valeur initiale de l'état de charge de la batterie, permettant de recaler l'estimation de l'état de charge lors des périodes de relaxation, même si lesdites périodes sont trop courtes pour que la batterie atteigne un état d'équilibre et donc que la relaxation de la batterie n'est pas assurée.

Le calcul de l'erreur due à la relaxation comprend de :

mémoriser des données de cartographie fournissant la correspondance d'un état de charge défini et d'une tension à vide définie de la batterie, pour une température donnée de la batterie,

déterminer une erreur maximale sur la mesure de la tension à vide correspondant à l'erreur entre la tension de batterie au réveil pour une durée de relaxation minimale et la tension de batterie au réveil pour ladite durée de relaxation cible,

fournir des données de calibration de l'erreur décrivant une variation d'une marge d'erreur sur l'état de charge par rapport à une valeur d'état de charge fournie par les données de cartographie, en fonction de ladite erreur maximale,

calculer ladite erreur due à la relaxation à partir de ladite mesure de tension à vide à l'instant de réveil de la batterie et desdites données de calibration.

Avantageusement, l'estimation de la valeur initiale dudit état de charge est calculée en prenant en compte le sens de polarisation en charge ou en décharge de la batterie à l'instant d'endormissement.

Avantageusement, l'estimation de la valeur initiale dudit état de charge est calculée en prenant en compte un paramètre représentatif de la durée effective d'endormissement de la batterie par rapport à la durée de relaxation cible de la batterie.

Avantageusement, pour un sens de polarisation en décharge à l'instant d'endormissement, si la valeur mémorisée d'état de charge SOCmem à cet instant est supérieure ou égale à la valeur calculée d'état de charge SOCocv à l'instant de réveil, l'estimation de la valeur initiale d'état de charge SOCini est calculée de la façon suivante :

$$SOCini = min(SOCmem, SOCocv+Err),$$

sinon :

$$SOCini = (1-a).SOCocv + a.(SOCocv+Err),$$

avec le paramètre a variant entre 0, si la durée la durée d'endormissement de la batterie est égale à la durée de relaxation cible de la batterie, et 1, si la durée d'endormissement de la batterie est égal au temps minimum requis entre une demande d'endormissement et une demande de réveil de la batterie.

Avantageusement, pour un sens de polarisation en charge à l'instant d'endormissement, si la valeur mémorisée d'état de charge SOCmem à cet instant est inférieure ou égale à la valeur calculée d'état de charge SOCocv à l'instant de réveil, l'estimation de la valeur initiale d'état de charge SOCini est calculée de la façon suivante :

$$SOCini = max(SOCmem, SOCocv-Err),$$

sinon :

$$SOCini = (1-a).SOCocv + a.(SOCocv-Err),$$

avec le paramètre a variant entre 0, si la durée la durée d'endormissement de la batterie est égale à a durée de relaxation cible de la batterie, et 1, si la durée d'endormissement de la batterie est égal au temps minimum requis entre une demande d'endormissement et une demande de réveil de la batterie.

Selon une variante, pour un sens de polarisation en décharge à l'instant d'endormissement, si la valeur mémorisée d'état de charge SOCmem à cet instant est inférieure à la valeur calculée d'état de charge SOCocv à l'instant de réveil, l'estimation de la valeur initiale d'état de charge SOCini est calculée de la façon suivante :

$$SOCini = (SOCocv+(SOCocv+Err))/2.$$

Selon une variante, pour un sens de polarisation en charge à l'instant d'endormissement, si la valeur mémorisée d'état de charge SOCmem à cet instant est supérieure à la valeur calculée d'état de charge SOCocv à l'instant de réveil, l'estimation de la valeur initiale d'état de charge SOCini est calculée de la façon suivante :

$$SOCini=(SOCocv+(SOCocv-Err))/2.$$

L'invention concerne également un dispositif de gestion d'une batterie, notamment une batterie de traction d'un véhicule électrique, caractérisé en ce qu'il comprend des moyens adaptés à la mise en oeuvre du procédé tel que décrit ci-dessus.

L'invention concerne encore un véhicule automobile électrique ou hybride rechargeable, caractérisé en ce qu'il comprend un dispositif tel que décrit ci-dessus.

D'autres caractéristiques et avantages de l'invention ressortiront de la description qui en est faite ci-après, à titre indicatif et nullement limitatif, en référence aux dessins annexés, dans lesquels :

[Fig. 1] illustre de façon schématique un dispositif de gestion d'une batterie adapté à la mise en oeuvre du procédé de l'invention ;

[Fig. 2] illustre un organigramme du procédé d'initialisation de l'état de charge de la batterie en relation avec le dispositif de la figure 1 ;

[Fig. 3] illustre un exemple de courbe de calibration d'erreur illustrant la variation de la marge d'erreur sur l'état de charge due à la relaxation, par rapport à la valeur d'état de charge estimée de la batterie au réveil.

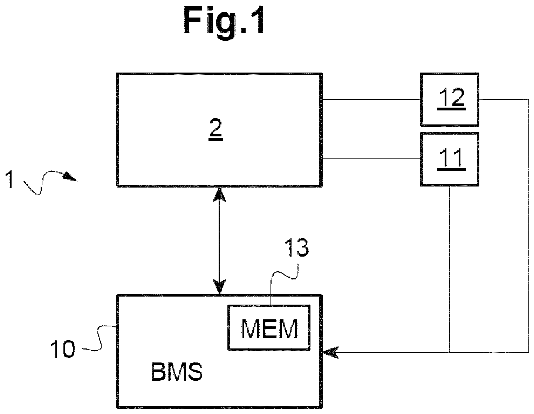

La figure 1 représente un dispositif comportant des moyens adaptés à la mise en oeuvre d'un procédé selon un mode de réalisation de l'invention. Le dispositif 1 comprend notamment un système 10 de gestion de batterie, ou BMS (Battery Management System). Le BMS 10 est relié à une batterie 2. Il est également relié à des moyens 11 de mesure de la température de la batterie et à des moyens 12 de mesure d'une tension aux bornes de la batterie, de tels moyens étant connus en soi. le BMS 10 comprend une mémoire 13 de type non volatile, pour stocker des données et en particulier, des données relatives à un état de charge estimé de la batterie SOCmem et à la polarisation de la batterie Signe_Polarisation (charge ou décharge) au moment de son endormissement, la durée de cet endormissement Rest_time, ainsi que la tension aux bornes de la batterie Ucell et la température T de la batterie à un instant de réveil de la batterie. Ces données permettent en particulier de juger de l'état de relaxation de la batterie au moment du réveil, comme on le verra plus en détail par la suite.

La mémoire 13 mémorise également, par exemple sous la forme d'une cartographie OCV=f(SOC), des données relatives à la correspondance d'un état de charge défini SOC et d'une tension à vide définie de la batterie OCV, pour une température donnée de la batterie. Ces données peuvent être obtenues par des essais préliminaires sur une telle batterie, dans différentes conditions de température. Ainsi, au moment du réveil de la batterie, la mesure de la tension à ses bornes correspond à sa tension à vide OCV, en l'absence de tout courant traversant la batterie et, à partir de la mesure de la tension à vide OCV à l'instant de réveil de la batterie et de la température de la batterie, le BMS 10 peut calculer un état de charge correspondant de la batterie SOCocv.

Le procédé d'initialisation vise à déterminer une valeur initiale d'état de charge qui soit fiable au réveil de la batterie. En effet, dans le cas où la relaxation de la batterie n'est pas assurée, la valeur d'état de charge basée sur la mesure de la tension à vide au réveil de la batterie souffre d'une erreur due à la relaxation de la batterie. Aussi, afin d'obtenir un ordre de grandeur représentatif de l'erreur commise sur les mesures effectuées de tension à vide de la batterie au réveil, une étape de calibration de cette erreur due à la relaxation est mise en oeuvre, comme il va être détaillé ci-après.

L'erreur dépend notamment de la durée des périodes de relaxation pour la batterie considérée. Aussi, on a par exemple établi des courbes de relaxation à différentes températures, chaque courbe correspondant à une température particulière. Préférentiellement, des courbes distinctes sont établies selon que la période de relaxation suit une polarisation de charge ou de décharge de la batterie.

Ces courbes de relaxation à différentes températures sont analysées et des durées de relaxation cibles Thresh sont identifiées pour chaque température.

Egalement, on va déterminer une erreur maximale Err_max sur la mesure de la tension à vide due à la non attente de la relaxation. Cette erreur est estimée en prenant en compte l'erreur entre la tension de batterie au réveil pour une durée de relaxation minimale, correspondant au temps minimum requis entre une demande d'endormissement et une demande de réveil de la batterie entre deux cycles, par exemple 1 minute, et la tension de batterie au réveil pour la durée de relaxation cible déterminée pour la température mesurée de la batterie, le tableau ci-dessous illustre un exemple d'une étude de relaxation menée à différentes températures pour déterminer les durées de relation cibles correspondantes et l'erreur maximale sur la mesure de la tension à vide en tenant compte du temps minimal du cycle endormissement/réveil de la batterie comme expliqué ci-dessus.

[Tableaux 1]

| Température (T°C) | Thresh (min) | Err_max (mV) |
|---|---|---|
| 25 | 35 | 7.5 |
| 0 | 95 | 22 |
| -10 | 140 | 30 |

L'erreur maximale sur la mesure de la tension à vide est ensuite convertie en erreur sur l'état de charge au moyen d'un calcul d'erreur effectué sur la cartographie OCV=f(SOC), établissant la correspondance entre l'état de charge de la batterie SOC et la tension au réveil de la batterie, soit la tension à vide de la batterie OCV, pour une température donnée de la batterie. Cette conversion de l'erreur maximale sur la mesure de la tension à vide en erreur sur l'état de charge s'effectue préférentiellement offline.

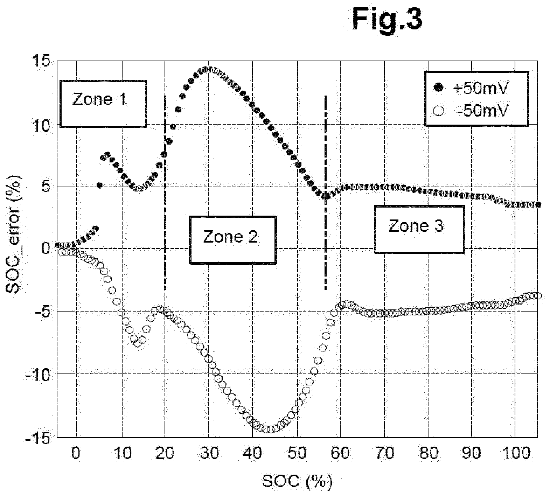

La figure 3 illustre le résultat de cette conversion pour un exemple d'erreur maximale déterminée de 50mV sur la valeur de la tension au réveil de la batterie. Ainsi, à partir de la cartographie réelle mémorisée pour une température donnée OCV=f(SOC), pour chaque valeur de la tension au réveil de la batterie, la valeur d'erreur maximale déterminée est prise en compte, ce qui fournit une marge d'erreur en plus et en moins pour la valeur correspondante d'état de charge. La figure 3 décrit la courbe de calibration de l'erreur qui en résulte illustrant la variation de cette marge d'erreur sur l'état de charge en pourcentage, SOC_error, par rapport à la valeur d'état de charge SOC fournie par la cartographie OCV=f(SOC).

Avantageusement, on peut décomposer cette courbe de calibration de l'erreur en plusieurs zones, de préférence au moins deux. La courbe de calibration selon l'exemple de la figure 3 comporte trois zones, référencées Zone_1, Zone_2 et Zone_3, correspondant chacune respectivement à une plage prédéfinie de valeurs d'états de charge. Ainsi, pour une valeur de tension de batterie mesurée au réveil, on obtient une valeur d'état de charge à partir de la cartographie OCV=f(SOC) et selon la plage prédéfinie d'états de charge dans laquelle est comprise cette valeur, on retiendra en tant qu'erreur Err due à la relaxation la valeur maximale estimée de la marge d'erreur SOC_error pour la plage prédéfinie d'état de charge considérée. Selon l'exemple de la figure 3, pour la plage prédéfinie d'états de charge Zone_1, l'erreur Err due à la relaxation est considérée égale à 7,5%, pour la plage prédéfinie d'états de charge Zone_2, l'erreur Err due à la relaxation est considérée égale à 15% et pour la plage prédéfinie d'états de charge Zone_3, l'erreur Err due à la relaxation est considérée égale à 5 %. Ainsi, la prise en compte d'une condition sur la tension de batterie au réveil, concernant l'appartenance à l'une de plusieurs zones prédéfinies, permet d'éviter de prendre une marge d'erreur maximale dans le calcul, mais d'adapter celle-ci au plus près de la marge d'erreur réelle.

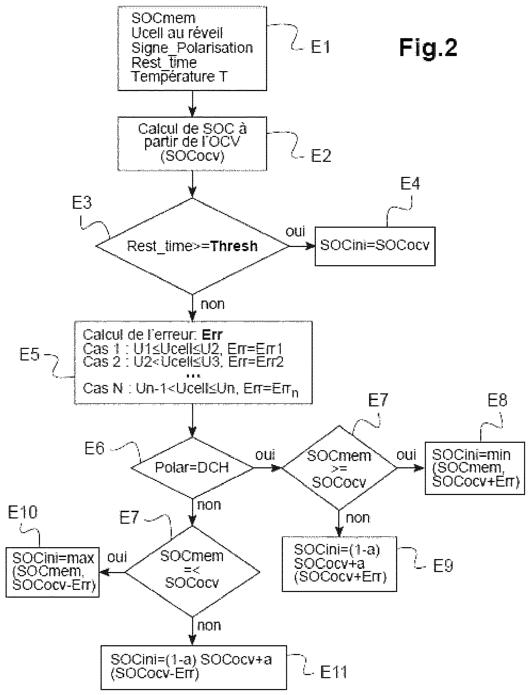

La figure 2 illustre un organigramme du procédé d'initialisation de l'état de charge de la batterie en relation avec le dispositif nécessaire à la mise en oeuvre, décrit à la figure 1. En premier lieu, dans une première étape E1, le BMS 10 récupère les données enregistrées dans la mémoire 13 comme indiqué plus haut, soient l'état de charge estimé de la batterie SOCmem au moment de son endormissement, la polarisation de la batterie Signe_Polarisation (charge ou décharge) au moment de l'endormissement, la valeur de la tension aux bornes de la batterie au réveil Ucell, la température T de la batterie à l'instant de réveil et enfin, la durée de l'endormissement Rest_time.

Une deuxième étape E2 consiste à calculer l'état de charge SOCocv déduit de la cartographie OCV=f(SOC) pour la température T de la batterie, à partir de la mesure directe de la tension de batterie au réveil Ucell correspondant à sa tension à vide OCV.

Ces deux étapes E1 et E2 correspondant à une phase d'initialisation. Suite à cette phase d'initialisation, on met en oeuvre une phase de calibration de l'erreur due à la relaxation selon les principes exposés ci-dessus.

Dans un premier temps, on compare dans une étape E3 la durée d'endormissement Rest_time par rapport à la durée de relaxation cible Thresh, issue de l'étude de la relaxation de la batterie concernée pour la température donnée T. Si la durée d'endormissement Rest_time de la batterie est supérieure ou égale à la durée de relaxation cible Thresh, alors, dans une étape E4, on affecte la valeur précédemment calculée d'état de charge SOCocv comme valeur initiale d'état de charge SOCini. En effet, on est ici dans une situation où le temps de relaxation nécessaire pour atteindre l'état d'équilibre de la batterie a été atteint ou dépassé et donc, la valeur de la tension de batterie mesurée au réveil OCV fournit de façon fiable la valeur initiale d'état de charge. Egalement, une étape de contrôle de l'accès à la mémoire 13 peut être mise en oeuvre à l'étape E3. Si la mémoire n'est pas accessible, alors on passe également à l'étape E4 et la valeur initiale d'état de charge SOCini est prise égale à valeur calculée d'état de charge SOCocv, aucune autre valeur n'étant disponible. Autrement dit, si la relaxation de la batterie est achevée ou que les informations stockées en mémoire ne sont pas disponibles pour une raison quelconque, la valeur initiale d'état de charge sera déterminée à partir de la valeur calculée d'état de charge SOCocv.

Par contre, si l'accès en mémoire est possible et que la durée d'endormissement Rest_time est inférieure à la durée de relaxation cible Thresh, alors on passe dans une étape E5 de calibration de l'erreur Err due à la relaxation. Selon les principes exposés ci-dessus, cette erreur est déterminée à partir de la courbe de calibration de l'erreur de la figure 3, en fonction de la valeur de la tension de batterie au réveil Ucell.

Une fois l'erreur Err due à la relaxation déterminée à l'étape E5, on passe dans une phase de calcul de la valeur initiale d'état de charge SOCini. On prévoit avantageusement de prendre en compte le sens de polarisation de la batterie dans le calcul de la valeur initiale d'état de charge. La prise en compte du sens de polarisation permet en effet de se rapprocher de la valeur réelle de l'état de charge en minimisant les erreurs de sur-estimation ou de sous-estimation de l'état de charge.

Ainsi, on met tout d'abord en oeuvre un test de polarisation dans une étape E6 pour déterminer le sens de polarisation au moment de l'endormissement. Ce test repose sur une analyse de la variation de la tension de batterie juste après l'endormissement. L'augmentation de la tension au tout début de la relaxation traduit un arrêt en décharge de la batterie, tandis qu'à l'inverse, une diminution de la tension au tout début de la relaxation traduit un arrêt en charge de la batterie. La variable Signe_Polarisation enregistrée en mémoire permet de traduire le résultat de ce test. Selon le sens de la polarisation de la batterie fourni à l'étape E6 par la variable Signe_Polarisation, une comparaison est réalisée dans une étape E7 entre l'état de charge estimé de la batterie SOCmem qui a été enregistré en mémoire au moment de l'endormissement et l'état de charge calculé SOCocv provenant de la mesure directe de la tension OCV de la batterie au réveil. Par la suite, en fonction de cette comparaison, une décision est prise pour déterminer la valeur initiale de l'état de charge, en utilisant l'erreur Err due à la relaxation qui a été déterminée à l'étape E5.

Dans le cas où la variable Signe_Polarisation enregistrée en mémoire traduit un arrêt en décharge (DCH) de la batterie au moment de l'endormissement, si l'état de charge estimé de la batterie SOCmem au moment de l'endormissement est supérieur ou égal à l'état de charge calculé au réveil SOCocv (SOCmem>=SOCocv), alors la valeur initiale d'état de charge SOCini est déterminée à l'étape E8 de la façon suivante :

$$SOCini = min(SOCmem, SOCocv + Err).$$

Par contre, toujours dans le cas un arrêt en décharge de la batterie au moment de l'endormissement, si SOCmem<SOCocv, alors la valeur initiale d'état de charge SOCini est déterminée dans une étape E9 de la façon suivante :

$$SOCini = (1-a).SOCocv + a.(SOCocv + Err),$$

avec $a$ étant un paramètre variant entre 0 et 1, représentatif de la durée d'endormissement Rest_time par rapport à la durée de relaxation cible Thresh de la batterie pour la température considérée. Plus précisément, $a = 0$, si la durée d'endormissement est égale à la durée de relaxation cible et $a=1$ si la durée d'endormissement est égale au temps minimal du cycle endormissement/réveil de la batterie, par exemple 1mn.

La prise en compte grâce au paramètre $a$ de la durée effective d'en endormissement par rapport à la durée de relaxation cible permet d'optimiser le calcul de la valeur initiale SOCini.

A l'étape E6, dans le cas où la variable Signe_Polarisation enregistrée en mémoire traduit un arrêt non plus en décharge, mais en charge de la batterie au moment de l'endormissement, si l'état de charge estimé de la batterie SOCmem au moment de l'endormissement est inférieur ou égal l'état de charge calculé au réveil SOCocv (SOCmem<=SOCocv), alors la valeur initiale d'état de charge SOCini est déterminée dans une étape E10 de la façon suivante :

$$SOCini = max(SOCmem, SOCocv - Err).$$

Par contre, toujours dans le cas un arrêt en charge de la batterie au moment de l'endormissement, si SOCmem>SOCocv, alors la valeur initiale d'état de charge SOCini est déterminée dans une étape E11 de la façon suivante :

$$SOCini = (1-a).SOCocv + a.(SOCocv - Err).$$

Le paramètre $a$ étant déterminé comme expliqué précédemment.

En variante, pour les cas de figures suivants, le calcul de la valeur initiale d'état de charge SOCini pourrait se calculer comme suit :

Dans le cas un arrêt en décharge de la batterie au moment de l'endormissement, si SOCmem<SOCocv, alors :

$$SOCini = SOCocv + (SOCocv+Err)/2.$$

Dans le cas un arrêt en charge de la batterie au moment de l'endormissement, si SOCmem>SOCocv, alors :

$$SOCini = SOCocv + (SOCocv-Err)/2.$$

Le procédé de l'invention permet donc à chaque initialisation de la valeur d'état de charge, de ramener cette valeur a une valeur plus réaliste physiquement et de s'affranchir ainsi d'un cumul d'erreur dur l'état de charge enregistré en mémoire.

## Revendications

1. Procédé d'estimation de l'état de charge d'une batterie (2) comprenant une phase d'initialisation de l'état de charge de la batterie incluant d'estimer une valeur initiale (SOCini) dudit état de charge, ladite phase d'initialisation comprenant des étapes de :

- réception (E1) d'une valeur mémorisée d'état de charge de la batterie (SOCmem) à un instant d'endormissement de la batterie,
- calcul (E2) d'une valeur d'état de charge (SOCocv) à partir d'une mesure de la tension à vide (Ucell) aux bornes de la batterie à un instant de réveil de la batterie,
ladite phase d'initialisation comprenant une étape de calcul (E5) d'une erreur (Err) sur la mesure de la tension à vide due à la relaxation de la batterie, dans laquelle ladite erreur est calculée en fonction de la température courante (T) de la batterie et d'une durée de relaxation cible (Thresh) de la batterie modélisée pour chaque température,
l'estimation de la valeur initiale dudit état de charge étant calculée sur la base d'une comparaison entre lesdites valeurs mémorisée (SOCmem) et calculées (SOCocv) d'état de charge et en fonction de ladite erreur calculée (Err)
le procédé étant **caractérisé en ce que** le calcul de l'erreur (Err) due à la relaxation comprend de :

- mémoriser des données de cartographie fournissant la correspondance d'un état de charge défini et d'une tension à vide définie de la batterie, pour une température donnée de la batterie,
- déterminer une erreur maximale sur la mesure de la tension à vide correspondant à l'erreur entre la tension de batterie au réveil pour une durée de relaxation minimale et la tension de batterie au réveil pour ladite durée de relaxation cible,
- fournir des données de calibration de l'erreur décrivant une variation d'une marge d'erreur sur l'état de charge (SOC_error) par rapport à une valeur d'état de charge (SOC) fournie par les données de cartographie, en fonction de ladite erreur maximale,
- calculer ladite erreur (Err) due à la relaxation à partir de ladite mesure de tension à vide (Ucell) à l'instant de réveil de la batterie et desdites données de calibration.

2. Procédé selon la revendication 1, **caractérisé en ce que** l'estimation de la valeur initiale dudit état de charge est calculée en prenant en compte le sens de polarisation en charge ou en décharge de la batterie à l'instant d'endormissement.

3. Procédé selon la revendication 2, **caractérisé en ce que** l'estimation de la valeur initiale dudit état de charge est calculée en prenant en compte un paramètre (a) représentatif de la durée effective d'endormissement de la batterie par rapport à la durée de relaxation cible de la batterie.

4. Procédé selon la revendication 3, **caractérisé en ce que** pour un sens de polarisation en décharge à l'instant d'endormissement, si la valeur mémorisée d'état de charge (SOCmem) à cet instant est supérieure ou égale à la valeur calculée d'état de charge (SOCocv) à l'instant de réveil, l'estimation de la valeur initiale d'état de charge (SOCini) est calculée de la façon suivante :

$$SOCini = min(SOCmem, SOCocv+Err),$$

sinon :

$$SOCini=(1-a).SOCocv+a.(SOCocv+Err),$$

avec le paramètre a variant entre 0, si la durée la durée d'endormissement de la batterie est égale à la durée de relaxation cible de la batterie, et 1, si la durée d'endormissement de la batterie est égal au temps minimum requis entre une demande d'endormissement et une demande de réveil de la batterie.

5. Procédé selon la revendication 3 ou 4, **caractérisé en ce que** pour un sens de polarisation en charge à l'instant d'endormissement, si la valeur mémorisée d'état de charge (SOCmem) à cet instant est inférieure ou égale à la valeur calculée d'état de charge (SOCocv) à l'instant de réveil, l'estimation de la valeur initiale d'état de charge (SOCini) est calculée de la façon suivante :

$$SOCini =max(SOCmem, SOCocv-Err),$$

sinon :

$$SOCini=(1-a).SOCocv+a.(SOCocv-Err),$$

avec le paramètre a variant entre 0, si la durée la durée d'endormissement de la batterie est égale à a durée de relaxation cible de la batterie, et 1, si la durée d'endormissement de la batterie est égal au temps minimum requis entre une demande d'endormissement et une demande de réveil de la batterie.

6. Procédé selon la revendication 2, **caractérisé en ce que** pour un sens de polarisation en décharge à l'instant d'endormissement, si la valeur mémorisée d'état de charge (SOCmem) à cet instant est inférieure à la valeur calculée d'état de charge (SOCocv) à l'instant de réveil, l'estimation de la valeur initiale d'état de charge (SOCini) est calculée de la façon suivante :

$$SOCini=(SOCocv+(SOCocv+Err))/2.$$

7. Procédé selon la revendication 2 ou 6, **caractérisé en ce que** pour un sens de polarisation en charge à l'instant d'endormissement, si la valeur mémorisée d'état de charge (SOCmem) à cet instant est supérieure à la valeur calculée d'état de charge (SOCocv) à l'instant de réveil, l'estimation de la valeur initiale d'état de charge (SOCini) est calculée de la façon suivante :

$$SOCini=(SOCocv+(SOCocv-Err))/2.$$

8. Dispositif (1) de gestion d'une batterie, notamment une batterie de traction d'un véhicule électrique, **caractérisé en ce qu'**il comprend des moyens adaptés à la mise en oeuvre du procédé selon l'une quelconque des revendications précédentes.

9. Véhicule automobile électrique ou hybride rechargeable, **caractérisé en ce qu'**il comprend un dispositif selon la revendication 8.

**Patentansprüche**

1. Verfahren zur Schätzung des Ladezustands einer Batterie (2), das eine Initialisierungsphase des Ladezustands der Batterie enthält, die das Schätzen eines Anfangswerts (SOCini) des Ladezustands umfasst, wobei die Initialisierungsphase die Schritte enthält:

   - Empfang (E1) eines gespeicherten Ladezustandswerts der Batterie (SOCmem) zu einem Einschlafzeitpunkt der Batterie,

- Berechnung (E2) eines Ladezustandswerts (SOCocv) ausgehend von einer Messung der Leerlaufspannung (Ucell) an den Klemmen der Batterie zu einem Aufwachzeitpunkt der Batterie,

wobei die Initialisierungsphase einen Schritt der Berechnung (E5) eines Fehlers (Err) bei der Messung der Leerlaufspannung aufgrund der Relaxation der Batterie enthält, wobei der Fehler abhängig von der aktuellen Temperatur (T) der Batterie und einer Ziel-Relaxationsdauer (Thresh) der Batterie berechnet wird, die für jede Temperatur modellisiert wird,

wobei die Schätzung des Anfangswerts des Ladezustands auf der Basis eines Vergleichs zwischen den gespeicherten (SOCmem) und berechneten (SOCocv) Ladezustandswerten und abhängig vom berechneten Fehler (Err) berechnet wird, wobei das Verfahren **dadurch gekennzeichnet ist, dass** die Berechnung des Fehlers (Err) aufgrund der Relaxation enthält:

- Speichern von Kennfelddaten, die die Entsprechung eines definierten Ladezustands und einer definierten Leerlaufspannung der Batterie für eine gegebene Temperatur der Batterie liefern,
- Bestimmen eines maximalen Messfehlers der Leerlaufspannung entsprechend dem Fehler zwischen der Batteriespannung beim Erwachen für eine minimale Relaxationsdauer und der Batteriespannung beim Erwachen für die Ziel-Relaxationsdauer,
- Liefern von Kalibrierungsdaten des Fehlers, die eine Variation einer Fehlermarge beim Ladezustand (SOC_error) bezüglich eines Ladezustandswerts (SOC) beschreiben, der von den Kennfelddaten geliefert wird, abhängig vom maximalen Fehler,
- Berechnen des Fehlers (Err) aufgrund der Relaxation ausgehend von der Leerlaufspannungsmessung (Ucell) zum Aufwachzeitpunkt der Batterie und den Kalibrierungsdaten.

2. Verfahren nach Anspruch 1, **dadurch gekennzeichnet, dass** die Schätzung des Anfangswerts des Ladezustands unter Berücksichtigung der Polarisierungsrichtung beim Laden oder Entladen der Batterie zum Einschlafzeitpunkt berechnet wird.

3. Verfahren nach Anspruch 2, **dadurch gekennzeichnet, dass** die Schätzung des Anfangswerts des Ladezustands unter Berücksichtigung eines für die effektive Einschlafdauer der Batterie bezüglich der Ziel-Relaxationsdauer der Batterie repräsentativen Parameters (a) berechnet wird.

4. Verfahren nach Anspruch 3, **dadurch gekennzeichnet, dass** für eine Polarisierungsrichtung beim Entladen zum Einschlafzeitpunkt, wenn der gespeicherte Ladezustandswert (SOCmem) zu diesem Zeitpunkt höher als der oder gleich dem berechneten Ladezustandswert (SOCocv) zum Aufwachzeitpunkt ist, die Schätzung des Ladezustand-Anfangswerts (SOCini) folgendermaßen berechnet wird:

$$SOCini=min(SOCmem, SOCocv+Err),$$

sonst:

$$SOCini=(1-a).SOCocv+a.(SOCocv+Err),$$

wobei der Parameter a zwischen 0, wenn die Einschlafdauer der Batterie gleich der Ziel-Relaxationsdauer der Batterie ist, und 1 variiert, wenn die Einschlafdauer der Batterie gleich der zwischen einer Einschlafanforderung und einer Aufwachanforderung der Batterie erforderlichen minimalen Zeit ist.

5. Verfahren nach Anspruch 3 oder 4, **dadurch gekennzeichnet, dass** für eine Polarisierungsrichtung beim Laden zum Einschlafzeitpunkt, wenn der gespeicherte Ladezustandswert (SOCmem) zu diesem Zeitpunkt niedriger als der oder gleich dem berechneten Ladezustandswert (SOCocv) zum Aufwachzeitpunkt ist, die Schätzung des Ladezustand-Anfangswerts (SOCini) folgendermaßen berechnet wird:

$$SOCini=max(SOCmem, SOCocv-Err),$$

sonst:

$$SOCini=(1-a).SOCocv+a.(SOCocv-Err),$$

wobei der Parameter a zwischen 0, wenn die Einschlafdauer der Batterie gleich der Ziel-Relaxationsdauer der Batterie ist, und 1 variiert, wenn die Einschlafdauer der Batterie gleich der zwischen einer Einschlafanforderung und einer Aufwachanforderung der Batterie erforderlichen minimalen Zeit ist.

6. Verfahren nach Anspruch 2, **dadurch gekennzeichnet, dass** für eine Polarisierungsrichtung beim Entladen zum Einschlafzeitpunkt, wenn der gespeicherte Ladezustandswert (SOCmem) zu diesem Zeitpunkt niedriger als der berechnete Ladezustandswert (SOCocv) zum Aufwachzeitpunkt ist, die Schätzung des Ladezustand-Anfangswerts (SOCini) folgendermaßen berechnet wird:

$$SOCini=(SOCocv+(SOCocv+Err))/2.$$

7. Verfahren nach Anspruch 2 oder 6, **dadurch gekennzeichnet, dass** für eine Polarisierungsrichtung beim Laden zum Einschlafzeitpunkt, wenn der gespeicherte Ladezustandswert (SOCmem) zu diesem Zeitpunkt höher ist als der berechnete Ladezustandswert (SOCocv) zum Aufwachzeitpunkt, die Schätzung des Ladezustand-Anfangswerts (SOCini) folgendermaßen berechnet wird:

$$SOCini=(SOCocv+(SOCocv-Err))/2.$$

8. Vorrichtung (1) zur Verwaltung einer Batterie, insbesondere einer Antriebsbatterie eines Elektrofahrzeugs, **dadurch gekennzeichnet, dass** sie Einrichtungen enthält, die für die Durchführung des Verfahrens nach einem der vorhergehenden Ansprüche geeignet sind.

9. Aufladbares Elektro- oder Hybridkraftfahrzeug, **dadurch gekennzeichnet, dass** es eine Vorrichtung nach Anspruch 8 enthält.

**Claims**

1. Method for estimating the state of charge of a battery (2) comprising an initialization phase of the state of charge of the battery that includes estimating an initial value (SOCini) of said state of charge, said initialization phase comprising the following steps:

   - reception (E1) of a memorized state-of-charge value of the battery (SOCmem) when the battery enters sleep mode,
   - calculation (E2) of a state-of-charge value (SOCocv) using a measurement of the no-load voltage (Ucell) at the terminals of the battery when the battery wakes,
   said initialization phase including a calculation step (E5) to calculate an error (Err) in the measurement of the no-load voltage due to the relaxation of the battery, in which said error is calculated as a function of the current temperature (T) of the battery and a target relaxation time (Thresh) of the battery modelled for each temperature, the estimate of the initial value of said state of charge being calculated on the basis of a comparison between said memorized values (SOCmem) and calculated values (SOCocv) of the state of charge and as a function of said calculated error (Err), the method being **characterized in that** the calculation of the error (Err) caused by relaxation involves:

   - memorizing map data correlating a given state of charge with a given no-load voltage of the battery, for a given temperature of the battery,
   - determining a maximum error in the measurement of the no-load voltage corresponding to the error between the battery voltage on waking for a minimum relaxation time and the battery voltage on waking for said target relaxation time,
   - providing error calibration data describing a variation of a margin of error in the state of charge (SOC_error) in relation to a state-of-charge value (SOC) provided by the map data, as a function of said maximum error,
   - calculating said error (Err) caused by relaxation using said no-load voltage measurement (Ucell) when the battery wakes and said calibration data.

**2.** Method according to Claim 1, **characterized in that** the estimate of the initial value of said state of charge is calculated as a function of whether the polarization direction of the battery corresponds to charging or discharging when entering sleep mode.

**3.** Method according to Claim 2, **characterized in that** the estimate of the initial value of said state of charge is calculated in consideration of a parameter (a) representing the actual sleeping time of the battery in relation to the target relaxation time of the battery.

**4.** Method according to Claim 3, **characterized in that** if the polarization direction corresponds to discharging when entering sleep mode and the memorized state-of-charge value (SOCmem) at that instant is equal to or greater than the calculated state-of-charge value (SOCocv) on waking, the estimate of the initial state-of-charge value (SOCini) is calculated as follows:

$$SOCini = min(SOCmem, SOCocv+Err),$$

otherwise:

$$SOCini=(1-a).SOCocv+a.(SOCocv+Err),$$

with the parameter a varying between 0 if the sleeping time of the battery is equal to the target relaxation time of the battery, and 1 if the sleeping time of the battery is equal to the minimum time required between a battery sleep request and a battery wake request.

**5.** Method according to Claim 3 or 4, **characterized in that** if the polarization direction corresponds to charging when entering sleep mode and the memorized state-of-charge value (SOCmem) at that instant is equal to or less than the calculated state-of-charge value (SOCocv) on waking, the estimate of the initial state-of-charge value (SOCini) is calculated as follows:

$$SOCini = max(SOCmem, SOCocv-Err),$$

otherwise:

$$SOCini=(1-a).SOCocv+a.(SOCocv-Err),$$

with the parameter a varying between 0 if the sleeping time of the battery is equal to the target relaxation time of the battery, and 1 if the sleeping time of the battery is equal to the minimum time required between a battery sleep request and a battery wake request.

**6.** Method according to Claim 2, **characterized in that** if the polarization direction corresponds to discharging when entering sleep mode and the memorized state-of-charge value (SOCmem) at that instant is less than the calculated state-of-charge value (SOCocv) on waking, the estimate of the initial state-of-charge value (SOCini) is calculated as follows:

$$SOCini=(SOCocv+(SOCocv+Err))/2.$$

**7.** Method according to Claim 2 or 6, **characterized in that** if the polarization direction corresponds to charging when entering sleep mode and the memorized state-of-charge value (SOCmem) at that instant is greater than the calculated state-of-charge value (SOCocv) on waking, the estimate of the initial state-of-charge value (SOCini) is calculated as follows:

$$SOCini=(SOCocv+(SOCocv-Err))/2.$$

8. Management device (1) for a battery, notably a traction battery of an electric vehicle, **characterized in that** it includes means for implementing the method according to any one of the preceding claims.

9. Rechargeable hybrid or electric motor vehicle, **characterized in that** it includes a device according to Claim 8.

# Fig.1

**Fig.2**

# Fig.3

**EP 3 948 316 B1**

## RÉFÉRENCES CITÉES DANS LA DESCRIPTION

**Documents brevets cités dans la description**

- EP 2101183 A1

- US 2014225621 A1